**Europäisches Patentamt**

**European Patent Office**

**Office européen des brevets**

(19)

(11) Veröffentlichungsnummer: **0 073 417**
**B1**

(12) # EUROPÄISCHE PATENTSCHRIFT

(45) Veröffentlichungstag der Patentschrift:
25.11.87

(21) Anmeldenummer: **82107543.9**

(22) Anmeldetag: **18.08.82**

(51) Int. Cl.⁴: **C 23 C 20/04, F 24 J 2/48**

(54) Verwendung homogener Beschichtungen aus zwei oder mehreren Metallen und/oder Metallverbindungen.

(30) Priorität: 27.08.81 DE 3133871

(43) Veröffentlichungstag der Anmeldung:
09.03.83 Patentblatt 83/10

(45) Bekanntmachung des Hinweises auf die Patenterteilung:
25.11.87 Patentblatt 87/48

(84) Benannte Vertragsstaaten:
CH DE FR GB IT LI

(56) Entgegenhaltungen:
EP-A-0 027 625
GB-A-894 852
GB-A-2 009 723
US-A-3 018 194
US-A-3 064 023
US-A-3 071 493
US-A-3 313 632
US-A-3 320 293

(73) Patentinhaber: **Ruhrchemie Aktiengesellschaft,
Bruchstrasse 219, D-4200 Oberhausen 13 (DE)**
Patentinhaber: **M A N Technologie GmbH,
Dachauer Strasse 667, D-8000 München 50 (DE)**

(72) Erfinder: **Cornils, Boy, Dr. Dipl.- Chem., Friedrich-
Ebert- Strasse 45, D-4220 Dinslaken (DE)**
Erfinder: **Tihanyi, Bela, Dr. Dipl.- Chem.,
Arndtstrasse 87, D-4200 Oberhausen 1 (DE)**
Erfinder: **Weber, Jürgen, Dr. Dipl.- Chem.,
Bunsenstrasse 17, D-4200 Oberhausen 13 (DE)**
Erfinder: **DeWin, Werner, Dipl.- Ing., Eickenhof 51,
D-4220 Dinslaken (DE)**
Erfinder: **Erben, Edwin, Dipl.- Ing., Eininger
Strasse 10 e, D-8000 München 50 (DE)**
Erfinder: **Mühlratzer, August, Dr. Dipl.- Chem.,
Lindenweg 8, D-8031 Gilching (DE)**

(74) Vertreter: **Reichelt, Karl- Heinz, Dr., Ruhrchemie
Aktiengesellschaft Abt. PLD Postfach 13 01 60,
D-4200 Oberhausen 11 (DE)**

## Beschreibung

Die Erfindung betrifft die Verwendung hochtemperaturstabiler Beschichtungen mit atomarer oder molekularer Verteilung der Metallkomponenten und mit hohem solaren Absorptionsvermögen und/oder niedrigem Wärmeemissionsvermögen für Solarkollektoren. Die Beschichtungen werden durch thermische Zersetzung von zwei- oder mehrkernigen Metallverbindungen, die in einer Flüssigkeit gelöst oder suspendiert sind, erhalten.

Es ist bekannt, dünne Schichten aus Metallen bzw. Metallverbindungen, die für Solarkollektoren Anwendung finden und die bei niedrigen Temperaturen gute Absorptions- und Emissionseigenschaften aufweisen, aus organischen oder anorganischen Metallverbindungen zu erzeugen. Üblicherweise erfolgt die Abscheidung der Metalle bzw. Metallverbindungen auf dem heißen Substrat durch thermische oder reaktive Verfahren.

Dünne Schichten aus Metallen oder Metallverbindungen auf metallischen oder nichtmetallischen anorganischen Substraten neigen bei höherer Temperatur zur Agglomeration. Dadurch ändern sich verschiedene physikalische Eigenschaften, die maßgebend für ihre Eignung als Solarkollektoren sind, erheblich.

Die Agglomeration besteht in vielen Fällen in einer irreversiblen Sammel- bzw. Rekristallisation. Um die ursprünglichen Schichteigenschaften zu erhalten, müssen sie verhindert oder zumindest unterdrückt werden. Eine Möglichkeit zur Erreichung dieses Zieles besteht im Einbau von Fremdstoffen, die die Sammel- bzw. Rekristallisation verlangsamen oder einschränken. Besondere Bedeutung kommt dabei der homogenen Verteilung der Metallkomponenten zu. Die Herstellung homogener Zweimetallkomponentenschichten ist schwierig, sie kann bisher befriedigend nur mit sehr hohem Aufwand an Kosten und Arbeitszeit erzielt werden. So lassen sich Schichten mit zwei oder mehreren Metallkomponenten in relativ feiner Verteilung durch physikalische Abscheidung wie Bedampfen, Zerstäuben (Sputtering) oder Ionenplattieren herstellen. Diese Verfahren werden bei hohem Vakuum ($10^{-3}$ bis $10^{-8}$ bar) ausgeübt. Ihre Durchführung im technischen Maßstab verursacht daher beträchtliche Investitionen und Betriebskosten.

Nach einem anderen Verfahren gewinnt man Schichten mit zwei oder mehreren Metallkomponenten durch Auftragen und Zersetzen von Pasten oder viskosen Lösungen, die durch Zusammenmischen der gewünschten Komponenten hergestellt wurden. Auf diesem Wege ist jedoch nur eine grobe Verteilung der Komponenten zu erhalten, bedingt durch die geringe Geschwindigkeit der Diffusion und die Schwierigkeit der Mischung viskoser Stoffe. Schließlich ist noch die gleichzeitige Abscheidung von zwei oder mehreren Metallkomponenten aus der Gasphase zu erwähnen.

Sie führt wegen der unterschiedlichen Dampfdrucke und Zersetzungstemperaturen der flüchtigen Metallverbindungen jedoch nur zu unzulänglichen Ergebnissen.

Zusammengefaßt läßt sich somit feststellen, daß die Verfahren zur Herstellung dünner Schichten aus zwei oder mehreren Metallkomponenten in homogener Verteilung auf einem Substrat wegen des hohen technischen Aufwandes oder wegen der ungenügenden Homogenität der Schichten unbefriedigend sind.

In der GB-A-20 09 723 ist die Herstellung einer Cadmiumstannat-Schicht auf einem Substrat beschrieben. Hierbei handelt es sich um das Auftragen einer definierten, zwei Metalle enthaltenden Verbindung.

Gegenstand der US-A-30 71 493 ist die Abscheidung von Legierungen auf geeignete Substrate durch Zersetzung bimetallischer metallorganischer Verbindungen. Die metallorganischen Verbindungen sind leichtflüchtig und gelangen aus der Gasphase auf das Trägermaterial.

Es bestand daher die Aufgabe, für die Verwendung als Absorberschichten oder Reflektoren in einem Absorber-Reflektor-Tandem für Solar-Kollektoren geeignete Beschichtungen aus zwei oder mehreren Metallen oder Metallverbindungen auf einem Substrat aufzufinden.

Die Erfindung besteht in der Verwendung homogener Beschichtungen aus zwei oder mehreren Metallen und/oder Metallverbindungen auf einem Substrat, welche Beschichtungen aus zwei- oder mehrkernigen in einer Flüssigkeit gelösten oder suspendierten Metallcarboxylaten, - alkoholaten und/oder -oxidcarboxylaten, die Eisen, Kobalt, Nickel, Molybdän, Chrom, Wolfram, Rhodium, Ruthenium, Platin, Palladium, Mangan, Magnesium, Aluminium und Rhenium enthalten, in reduzierender, oxidierender oder inerter Atmosphäre durch Pyrolyse auf dem Substrat aufgebracht werden, als Absorberschichten oder Reflektoren in einem Absorber-Reflektor-Tandem für Solarkollektoren.

Die Beschichtung wird nach an sich bekannten Verfahren vorgenommen. So hat sich die unter der bezeichnung CVD (Chemical Vapor Deposition) praktizierte Arbeitsweise bewährt. Sie beruht auf der Abscheidung von Feststoffen wie Metallen, Metalloxyden, Carbiden durch thermischen Zerfall oder durch chemische Reaktion der flüchtigen Ausgangsverbindung mit einem oder mehreren Reaktionspartnern aus der Gasphase auf einem heißen Substrat.

Die hierbei ablaufenden Umsetzungen können z. B. Reduktion, Hydrolyse oder auch kompliziertere Reaktionen sein, wie sie bei der Abscheidung von TiC aus $TiCl_4$, $CCl_4$ und $H_2$ ablaufen. Die Abscheidung des Feststoffes stellt eine heterogene Reaktion an der Oberfläche des Substrates dar.

Die flüchtigen Reaktionsteilnehmer werden zumeist mit Hilfe eines inerten Trägergases wie Stickstoff in den Reaktionsraum transportiert.

Ein anderer Weg, die Beschichtung vorzunehmen, besteht in der Pyrolyse, der Ausgangsverbindung aus flüssiger Phase. Hierbei werden Lösungen oder Suspensionen eines thermisch zersetzbaren Stoffes auf die Substrat-Oberfläche aufgebracht, angetrocknet und auf Temperaturen oberhalb deren die Zersetzung eintritt erhitzt.

Die nach dem erfindungsgemäßen Verfahren hergestellte Schicht auf dem Substrat enthält die Metallkomponenten atomar bzw. molekular homogen verteilt. Hierdurch wird sichergestellt, daß eine Sammel- bzw. Rekristallisation der Bestandteile der Beschichtung unterbleibt.

Die Herstellung der Beschichtung kann auf jedem beliebigen metallischen oder nichtmetallischen Substrat erfolgen. Geeignet sind Stähle verschiedener Zusammensetzung oder Metalle wie Nickel, Kobalt, Molybdän, Titan, Silber, Gold, Platin. Auch anorganische Stoffe wie Metalloxide, Graphit, Gläser und organische Substrate, wie thermisch beständige Kunststoffe können eingesetzt werden. Das Substratmaterial und seine Vorbehandlung hängt von der vorgesehenen Anwendung ab.

Besondere Bedeutung besitzt die neue Arbeitsweise für die Herstellung von Solarbeschichtungen. Sie erlaubt es sowohl Absorberschichten als auch Reflektorschichten zu erzeugen.

Unter zwei-oder mehrkernigen Metallverbindungen im Sinne der vorliegenden Erfindung werden Verbindungen verstanden, die in einem Molekül mindestens zwei verschiedene Metallatome enthalten. Die Metalle sind dabei Eisen, Kobalt, Nickel, Molybdän, Chrom, Wolfram, Rhodium, Ruthenium, Platin, Palladium, Mangan, Magnesium, Aluminium und Rhenium.

Als mehrkernige Metallverbindungen finden Carboxylate, Alkoholate und/oder Oxidcarboxylate Anwendung. Beispiele für Verbindungen die in dem erfindungsgemäßen Prozeß eingesetzt werden können sind

Kobalt-nickelcitrat
Molybdänsäure-kobaltcitrat
Mangan-kobaltoxid-2-ethylhexanoat
Chrom-nickeloxid-2-ethylhexanoat
Nickel-Aluminiumisopropylat
Mangan-Aluminiumisopropylat
Chrom-Aluminiumisopropylat

Die stöchiometrische Zusaummensetzung der zwei- und mehrkernigen Verbindungen legt auch das Verhältnis fest, in dem die Metalle in der Beschichtung enthalten sind. Entsprechend der Zugänglichkeit der erfindungsgemäß eingesetzten Metallverbindungen liegt das atomare Verhältnis von zwei verschiedenen Metallen A und B vorwiegend im Bereich A:B = 2:1 bis 1:2. Auch atomare Verhältnisse mit A:B > 2 und A:B < 0,5 sind möglich, jedoch entsprechend der geringen Verfügbarkeit mehrkerniger Verbindungen derartiger Zusammensetzungen, seltener. Die Herstellung der zwei- oder mehrkernigen Verbindungen ist bekannt, sie wird weiter unten an einigen Beispielen beschrieben.

Zusammensetzung, Eigenschaften sowie Haftfestigkeit der aufgebrachten Schichten hängen entscheidend davon ab, ob der Prozeß in reduzierender, oxidierender oder inerter Atmosphäre erfolgt. Weitere Parameter, die auf die Art der Schicht Einfluß haben, sind insbesondere Substrattemperatur, Dampfdruck, wenn die Abscheidung aus der Gasphase erfolgt und Abscheidungsgeschwindigkeit.

Die hergestellten Beschichtungen eignen sich je nach Abscheidebedingungen hervorragend als Reflektoren in einem Absorber-Reflektor-Tandem für Solarkollektoren und ebenso als Absorberschichten für die gleiche Anwendung.

Verwendet man Inertgase wie Argon oder Stickstoff unter Zusatz von Sauerstoff, so werden Beschichtungen erzielt, die überwiegend Oxide enthalten. Führt man die Abscheidung in einem Kohlenmonoxidstrom oder in einem Gemisch aus Kohlenmonoxid und Inertgas durch, so gelangt man zu Beschichtungen, die überwiegend aus Carbiden bestehen.

Die angewandte Temperatur und die Geschwindigkeit des Trägergases haben maßgeblichen Einfluß auf die Ausbildung der Schichtstruktur, da sie Keimbildung und Keimwachstum wesentlich beeinflussen.

Die Schichten können zur Erhaltung ihrer Eigenschaften einer reaktiven oder thermischreaktiven Nachbehandlung unterzogen werden. Hierunter sind z.B. Oxidations- oder Reduktionsprozesse zu verstehen. Eine Oxidation ist unter anderem dann von Vorteil, wenn eine strukturierte Metallschicht durch eine oberflächliche Oxidschicht vor weiterer Oxidation geschützt werden soll. Reduktionen werden z.B. dann verwendet, wenn reine metallische oder oxidische/metallische Schichten erzeugt werden sollen.

Die Beschichtungen zeigen an der Oberfläche eine durch Oberflächenmikroanalyse nachweisbare gleichmäßige Verteilung der Metallkomponenten, die auch nach Behandlung der Schichten bei höherer Temperatur erhalten bleibt.

**Beispiel 1**

Zur Herstellung eines Co-Ni-mischcarboxylates des Kobalts werden 211,2 g Citronensäure in 900 ml Wasser bei etwa 80° C gelöst und unter langsamer Zugabe von 78,8 g Kobalt(II)-hydroxidcarbonat bei einer Temperatur von 100° C partiell umgesetzt. Nach 20 Minuten Reaktionszeit gibt man zu dem Reaktionsgemisch 96,7 g Nickel(II)-hydroxidcarbonat. Nach Auflösung der Nickelverbindung wird die Lösung einer fraktionierten Kristallisation unterworfen. Die in der Hauptfraktion bei etwa 20° C anfallenden 185,8 g Kristallisat enthalten 14,7 Gew.-% Kobalt und 16,7 Gew.-% Nickel.

Zur Beschichtung eines mit Benzol gereinigten Werkstückes wird eine Zubereitung aus Kobalt-Nickelcitrat in einem Gemisch von Leinöl, 2-Ethylhexansäure und n-Butanol auf die Oberfläche des Werkstückes aufgebracht und nach Antrocknen in Luftatmosphäre in einem Luftstrom bei 350°C zersetzt. Die Oberfläche ist homogen und zeigt bei mikroanalytischer Untersuchung an verschiedenen Stellen übereinstimmend ein Metallverhältnis von Ni/Co = 1,07.

## Beispiel 2

Zur Herstellung eines Co-Mn-Mischmetallcarboxylates löst man 99,4 g Kobalt(II)-acetat-4-hydrat zusammen mit 98,2 g Mangan(II)-acetat-4-hydrat in 300 ml Wasser. Durch Zusatz von 115 g 2-Ethylhexansäure wird ein Teil der Essigsäure ausgetauscht und in Gegenwart von 450 g Dekalin destillativ ausgetragen. Nach Abschluß dieser Reaktion ist bei etwa 190°C mittels Wasserdampf die noch vorhandene Acetoxy-Gruppe unter Bildung der Metall-hydroxid-2-ethylhexanoate zu substituieren. Die Verknüpfung wird durch weitere thermische Behandlung unter gleichzeitigem Wasseraustrag erreicht. Es bilden sich 172 g eines bivalenten Mangan-Kobaltoxid-2-ethylhexanoats von Typus R - COOMn -O-Co-OOCR, das 13,6 Gew.-% Kobalt und 12,7 Gew.-% Mangan enthält.

Ein vorgereinigtes Werkstück wird nach dem im Beispiel 1 beschriebenen Verfahren mit Mangan-kobalt-oxid-2-ethyl-hexanoat in einer Zubereitung aus Leinöl, 2-Ethylhexansäure und Butanol beschichtet und nach Antrocknen in Luftatmosphäre auf 500°C erhitzt. Die bräunliche Oberfläche ist homogen und zeigt an fünf verschiedenen Stellen ein konstantes Mn/Co-Verhältnis.

## Patentanspruch

Verwendung homogener Beschichtungen aus zwei oder mehreren Metallen und/oder Metallverbindungen auf einem Substrat, welche Beschichtungen aus zwei- oder mehrkernigen in einer Flüssigkeit gelösten oder suspendierten Metallcarboxylaten, -alkoholaten und/oder -oxidcarboxylaten, die Eisen, Kobalt, Nickel, Molybdän, Chrom, Wolfram, Rhodium, Ruthenium, Platin, Palladium, Mangan, Magnesium, Aluminium und Rhenium enthalten, in reduzierender, oxidierender oder inerter Atmosphäre durch Pyrolyse auf dem Substrat aufgebracht werden, als Absorberschichten oder Reflektoren in einem Absorber-Reflektor-Tandem für Solarkollektoren.

## Claim

The use of homogeneous coatings comprising two or more metals and/or metal compounds on a substrate as absorber layers or reflectors in an absorbor/reflector tandem for solar collectors, the coatings consisting of binuclear or polynuclear metal carboxylates, alcoholates and/or oxide carboxylates dissolved or suspended in a liquid and containing iron, cobalt, nickel, molybdenum, chromium, tungsten, rhodium, ruthenium, platinum, palladium, manganese, magnesium, aluminium and rhenium being applied to the substrate by pyrolysis in a reducing, oxidising or inert atmosphere.

## Revendication

Utilisation de revêtements homogènes de deux ou plusieurs métaux ou composés métalliques sur un substrat, ces revêtements étant appliqués sur le substrat par pyrolyse en atmosphère réductrice, oxydante ou inerte à partir de carboxylates, alcoolates et/ou oxydes-carboxylates métalliques di- ou polynucléaires qui contiennent du fer, du cobalt, du nickel, du molybdène, du chrome, du tungstène, du rhodium, du ruthénium, du platine, du palladium, du manganèse, du magnésium, de l'aluminium et du rhénium, comme couches absorbantes ou réfléchissantes dans un couple absorbeur-réflecteur pour collecteurs solaires.